Europäisches Patentamt

European Patent Office

Office européen des brevets

(11) Publication number: **0 406 506 A1**

## EUROPEAN PATENT APPLICATION

(21) Application number: **89810515.0**

(51) Int. Cl.⁵: **H01L 33/00, H01S 3/025**

(22) Date of filing: **07.07.89**

(43) Date of publication of application:
**09.01.91 Bulletin 91/02**

(84) Designated Contracting States:
**DE FR GB IT**

(71) Applicant: **International Business Machines Corporation**
**Old Orchard Road**
**Armonk, N.Y. 10504(US)**

(72) Inventor: **Harder, Christoph Stephan, Dr.**
**Renggerstrasse 66**
**CH-8038 Zürich(CH)**
Inventor: **Meier, Heinz Peter, Dr.**
**Langruetistrassel**
**Ch-8800 Thalwil(CH)**
Inventor: **Van Zeghbroeck, Bart Jozef**
**Reidholzstrasse 26 A**
**CH-8805 Richterswil(CH)**
Inventor: **Walter, Willi**
**Baumgartenweg 2**
**CH-8134 Adliswil(CH)**

(74) Representative: **Schröder, Otto H., Dr. Ing. et al**
**IBM Corporation Säumerstrasse 4**
**CH-8803 Rüschlikon(CH)**

(54) **Opto-electronic light emitting semiconductor device.**

(57) Opto-electronic light emitting device (30) epitaxially grown in III-V technology. It consists of a light emitting element (10), such as a diode laser or a LED, arranged back-to-back on a pn-junction diode (35), e.g., a PIN diode structure. A common middle layer (33) is transparent for the emitted wavelength and allows strong optical coupling (of at least 50 %) of the spontaneous isotropic radiation emitted by the light emitting element (10) to the diode (35) where the light is absorbed and recuperated for feedback to the light emitting element. The diode can be operated either as a photodiode or as a solar cell (by applying either a reverse- or a forward-bias voltage) resulting in regaining of either current or energy.

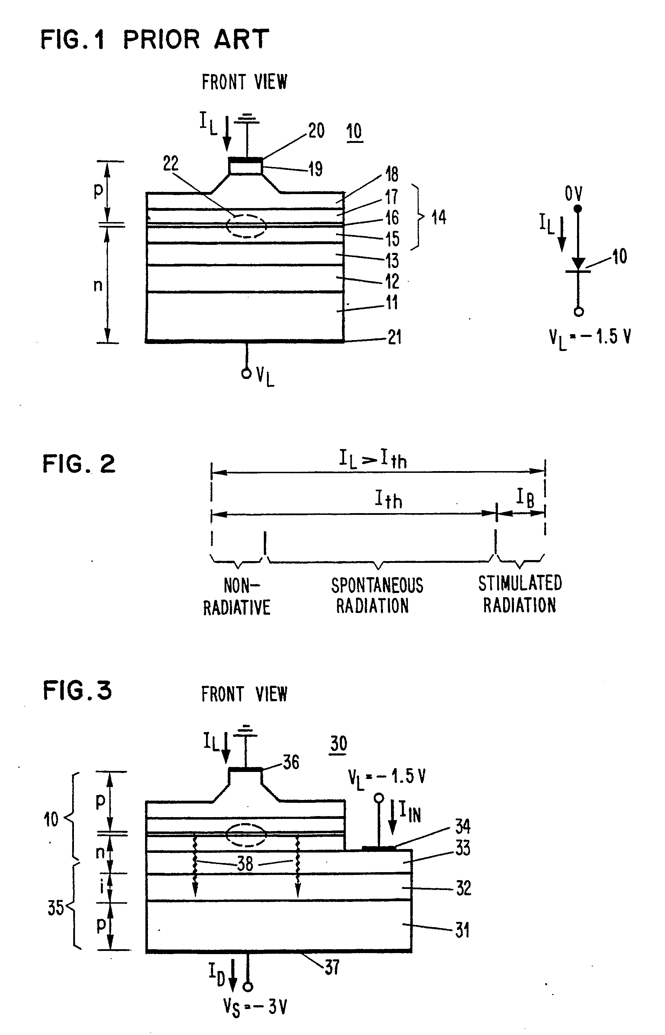

FIG.3 FRONT VIEW

## OPTO-ELECTRONLC LIGHT EMITTING SEMICONDUCTOR DEVICE

### Technical Field

The invention concerns light emitting semiconductor devices such as diode lasers or light emitting diodes that are formed in a structure of III-V- compound layers grown on a substrate and, more particularly, devices in which light emitting elements are integrated with other electronic or opto-electronic components to further improve performance.

### Background of the Invention

Light emitting semiconductor devices have found applications in a wide variety of information handling systems because of their compact size and because their technology is compatible with that of the associated electronic circuitry. They are being used in areas such as data communications, optical storage and optical beam printing and have been optimized for the particular applications regarding the emitted wavelength, optical power, their high speed switching or modulation capabilities, beam quality, and others.

In addition to these characteristics, there is the common requirement for low power dissipation, achieved with low threshold or high efficiency devices and by keeping the required control energy at a low level, this resulting in lower operating temperatures and, therefore, better reliability, increased lifetime and even in the elimination of the need for light output monitoring devices or circuits.

Numerous approaches have been made aiming at improvements in these latter areas, some involving combining or integrating light emitting elements, particularly diode lasers, with other electronic or opto-electronic devices. Some of these approaches, representing the present state of the art, are described in the following publications :

- European Patent Application 0 260 439 discloses a semiconductor light emission system comprising a diode laser and, formed within the same layered structure, a bipolar transistor. The radiant power can be controlled by small currents injected into the transistor base and, consequently, the laser. The transistor operates as an electronic device, not opto-electronically. The system does not provide for internal optical coupling or feedback.

- Article "Opto-Electronic Amplifier and Logic Element", published in IBM's Technical Disclosure Bulletin (Vol.31, No.12, May 1989, p 180), describes an opto-electronic device comprising a laser diode grown on a phototransistor structure, both separated by a blocking layer which prevents positive feedback. The device acts as the optical equivalent of a transistor and can be used as an amplifier or as logic element. Optical coupling is intentionally avoided by the the blocking layer.

- Article "Opto-Electronic Integrated Device with Light Amplification and Optical Bistability", by A.Sasaki et al (IEEE Transactions on Electron Devices, Vol.ED-31, No.6, June 1984, pp 805-811). Here, a device comprising a light emitting diode integrated into the collector of a heterojunction phototransistor is discussed. Light incident on the device is absorbed in the transistor base region where electron-hole pairs are created. Electron-hole recombination occurs in the active layer of the diode, as a result radiating light as the output. Overall optical gain is achieved. An absorption layer suppresses positive feedback, thus avoiding radiation emitted from the light emitting diode to be transmitted to the transistor,

- Article "Integrated Laser/Phototransistor Opto-Electronic Switching Device by Organometallic Vapour Phase Epitaxy" by C.F.Schaus et al (Electronics Letters, 24th April 1986, Vol.22, No.9, pp 454-456). Described is a structue in which a quantum well laser and a bipolar phototransistor are combined to realize a two-terminal opto-electronic switch. The DC I/V characteristics are typical of an npnp structure. Light incident on the phototransistor is amplified, gain being provided by the phototransistor and optical feedback. In the described structure, the optical coupling between the laser and the phototransistor is inherently low. In operation, the device will latch, i.e., show a behavior which is highly undesirable for many applications.

The devices known from these and other references do not show or suggest the integrated structure of the present invention or its basic concept which requires strong optical coupling between the integrated device elements and regaining of radiated energy to provide for positive feedback. In the state of the art devices, coupling of the combined elements is either only electrical or the optic coupling is intentionally prevented or held at a level that is too low as to allow the device to operate like the inventive device herein described.

2

EP 0 406 506 A1

## Summary of the Invention

It is a main object of the present invention to provide a light emitting semiconductor device with low power dissipation and thus reduced self- heating thereby improving device reliability and lifetime and/or increasing device packaging density without additional cooling requirements.

Another object is to provide a device of minimal temperature sensitivity that does not require monitoring or feedback circuitry to control the optical output power.

Still another object is to provide a device of high electric-to-radiant energy conversion efficiency which is operable at high speed.

A further object is to provide a device that can be switched or modulated by applying low energy control signals.

Another main object is to provide a light emitting device with minimized self-heating that can be fabricated using conventional, easy-to-control processes.

The invention as claimed in claim 1 is intended to meet these objectives and to remedy the drawbacks hitherto encountered. In the inventive device this is accomplished by a back-to-back arrangement of a light emitting element and a pn-junction, both epitaxially grown, where the two elements are optically coupled so that at least 50 % of the electric current or energy fed into the light emitting element and emitted as spontaneous radiation can be recuperated at the pn-junction and fed back to the light emitting element. A middle layer, common to both elements and transparent for the emitted wavelength, is provided with an ohmic contact for applying control signals to the device.

In the specific embodiments of the invention described hereinafter, the light emitting element takes the form of a diode laser, e.g., a ridge waveguide structure or a channeled substrate surface device, or is a light emitting diode (LED). On the other hand, it will be shown that the pn-junction can be either reverse biased, thus operating as a photodiode with electron-hole pair generation resulting in a current increase, or forward biased, then acting as a solar cell converting radiant energy from the light emitting element into electrical energy.

The advantages offered by the invention are mainly that the device provides for:
- switching with low current control signals,
- reduced power dissipation and self-heating which, in turn, results in improved reliability and lifetime and increased packaging density,
- operation characteristics that are less temperature dependent whereby the need for monitor devices and/or feedback circuitry for controlling the optical output power is eliminated, and
- particularly for light emitting diodes (LED), substantially improved electrical to optical power conversion efficiency and, due to high carrier densities, higher operation speed.

## Description of the Drawings

Various ways of implementing the invention are described in detail below with reference to drawings which illustrate specific embodiments and in which

**Fig. 1** is a schematic front view of a conventional ridge quantum well (QW) graded-index separate confinement heterostructure (GRINSCH) diode laser; an insert shows the equivalent circuit diagram. (PRIOR ART)

**Fig. 2** Illustrates schematically the conversion of electric energy, fed into a light emitting element through electric currents, to non-radiative, spontaneous radiative and stimulated radiative emission.

**Fig. 3** is a schematic front view of a light emitting device structured in accordance with the invention : a ridge GRINSCH diode laser serves as a light emitting element which is optically coupled with a pn-junction diode wherein the latter can be operated either as a photodiode or as a solar cell,

**Fig. 4A** is a I/V diagram of the pn-junction diode used in the structure of Fig .3, in which the operational points for either photodiode or solar cell operation of the pn-junction are indicated

**Fig. 4B** shows equivalent circuit diagrams for the device of Fig.3, with the pn-junction operated as either photodiode or solar cell,

**Fig. 5** is a diagram showing, for a conventional laser and for a light emitting device built in accordance with the invention, the optical output power as a function of the applied driver current,

**Fig. 6** is a schematic side view of a further light emitting device structured in accordance with the invention : a light emitting diode (LED) serves as light emitting element which is optically coupled with a

3

pn-junction diode.


Detailed Description of the Invention


Before discussing the invention in greater detail, a conventional diode laser structure will be described that may be integrated with a pn-junction diode as suggested by the invention to further improve device performance.

Fig.1 is a schematic front view of a GaAs/AlGaAs ridge waveguide graded-index separate confinement heterostructure (GRINSCH) diode laser. The laser structure 10 is grown on an n + - doped GaAs substrate 11 by, e.g., molecular beam epitaxy (MBE). First, a silicon-doped buffer layer 12 (1 $\mu$m GaAs, n = 1x $10^{18}$cm$^{-3}$) is grown on the substrate. Next is a lower cladding layer 13 (1 $\mu$m Al$_{0.45}$Ga$_{0.55}$As, n = 5 x $10^{17}$cm$^{-3}$). The core 14 of the laser consists of a graded n-type region 15 (0.2 $\mu$m Al$_{0.45}$Ga$_{0.55}$ As graded towards Al$_{0.18}$Ga$_{0.82}$ As, n = 2 x $10^{17}$cm$^{-3}$), an undoped active region forming a quantum well (7nm GaAs), and a graded p-type region 17(0.2 $\mu$m Al$_{0.18}$Ga$_{0.82}$ As graded towards Al$_{0.45}$Ga$_{0.55}$ As, p=2 x $10^{17}$cm$^{-3}$). The top cladding layer 18 (1$\mu$m Al$_{0.45}$Ga$_{0.55}$ As, p= 5 x $10^{17}$cm$^{-3}$) is followed by a p+ contact layer 19 (40nm GaAs, p= $10^{20}$cm$^{-3}$). The doping density of the layer 19 is high enough for a titanium, platinum and gold electrode 20 to make good ohmic contact. Ohmic contact 21 to the bottom side of the n-type substrate 11 is obtained by alloying germanium, gold and nickel.

When applying a voltage V$_L$ of sufficient level, e.g., - 1,5 V, to feed a current I$_L$ through the device that exceeds the threshold current I$_{th}$ of the device, the laser beam parallel to the plane of the active layer 16 is emitted in the light mode region 22.

The insert of Fig.1 shows the equivalent circuit diagram of the laser. It corresponds to that of a forward biased diode.

A more detailed description of a ridge GRINSCH laser is given in the article "High-Power Ridge-Waveguide AlGaAs GRINSCH Laser Diode" by C.Harder et al (Electronics Letters, 25th September 1986, Vol. 22, No.20, pp 1081-1082).

In such a diode laser structure, power dissipation below threshold (I$_L$ = I$_{th}$) is due to the recombination of electrons and holes in the quantum well. This is either non-radiative or radiative.

This is schematically illustrated in Fig .2.

In the non-radiative process, the energy is directly converted into heat whereas the radiated energy is absorbed mainly in the buffer layer 12 and/or the substrate 11 underneath the laser structure, where it is eventually also converted into heat.

When the current I$_L$ through the device is larger than the threshold current I$_{th}$, the portion 1$_B$ exceeding I$_{th}$ provides the power for the stimulated emission, i.e., the laser beam.

The basic concept on which the present invention is based, is to capture the spontaneous radiation which is emitted in random directions, and to "use" it before it is converted into heat. With this, device operation can be improved with regard to the magnitude of the input current that is required for switching or modulating the laser, the power dissipated in the laser which is responsible for the self- heating of the device, and also the temperature sensitivity which, in conventional lasers, makes beam monitoring and temperature effect compensation necessary.

Referring now to Fig.3, there is shown a schematic front view of a first embodiment of the light emitting device built in accordance with the present invention.

The device consists of a ridge GRINSCH laser 10 serving as light emitting element and, below that, a pn-junction diode 35. Laser and diode are epitaxially grown back-to-back on a p-doped GaAs substrate 31 as shown in the drawing. The laser 10 corresponds to that illustrated in Fig.1 whereas the diode part 35 is a so-called PIN diode, i.e., a 3-layer structure consisting of the p-doped GaAs substrate 31, intrinsic layer 32 (3 $\mu$m GaAs, undoped), and n-type layer 33 (1 $\mu$m Al$_{0.45}$Ga$_{0.55}$ As, n = 5 x $10^{17}$cm$^{-3}$. The latter also serves as lower cladding layer (13 in Fig.1) for the laser 10, i.e., it is common to both, the laser and the PIN diode.

The structure 30 is provided with top and bottom ohmic contacts 36 and 37, respectively. A further ohmic contact 34 is connected to the common middle layer 33.

Basically, laser 10 and diode 35 are two separate elements. With proper voltages applied, laser current I$_L$ will flow from contact 36 through the laser to contact 34 (where a control input current I$_{IN}$ can be injected), whereas pn-diode current flows between contacts 34 and 37. However, strong optical coupling exists between these elements. With a current I$_L$ flowing through the laser, isotropic radiation from the quantum well is coupled directly or indirectly, after single or multiple reflections, effectively into the pn-junction of the diode structure 35.

The device 30 can be operated in two different modes depending on the voltage $V_{LS}$ (= $V_L$ - $V_S$) applied across the diode junction, i.e., between contacts 34 and 37. With the diode being reverse biased, it operates as a photodiode which, when exposed to light, generates electron-hole pairs resulting in an increase in current flow. When the diode is, however, forward biased, it operates as a solar cell which converts radiant energy into electrical energy.

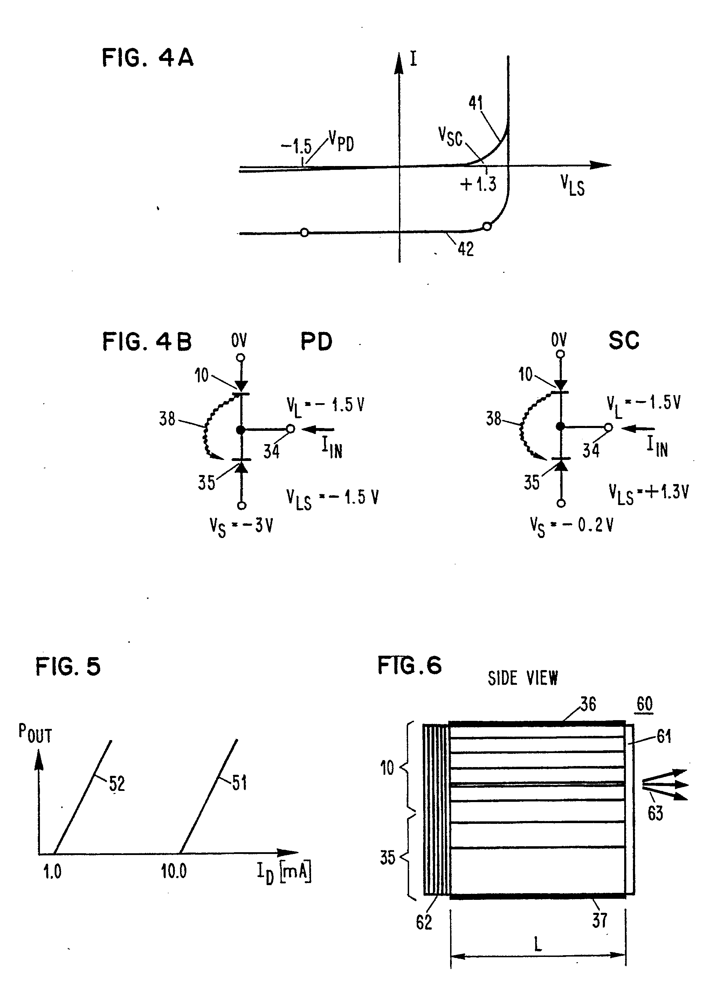

This difference in operation is illustrated in the drawings of Fig. 4A and 4B. Fig.4A shows the relevant part of the I/V-diagram of the PIN diode. Curve 41 represents the no-light-impinging situation whereas curve 42 is shifted downwards towards higher negative currents I due to the absorbed light of a given intensity. With a negative reverse bias voltage $V_{LS}$ applied ($V_{PD}$ of -1.5 V for the device of Fig.3), the diode 35 operates as photodiode. With a positive, forward bias voltage $V_{LS}$ applied ($V_{SC}$ of + 1.3V for the device of Fig.3), the device operates as a solar cell.

Fig.4B shows the equivalent circuit diagrams for the two operating modes : The diagram at the left represents the photodiode (PD) operation and the other, at the right hand side, the solar cell mode (SC). The reference numbers correspond to those used in Fig.3 and 4A. Arrows 38 represent the light coupled from the laser 10 to the pn-junction 35. The diagrams show that the two modes of operation do not require basically different devices but that the distinction is merely in the applied voltages over the pn-junction.

When device 30 is operated in the photodiode mode, current $I_L$, flowing through the laser, results (as illustrated in Fig.2) in the emission of spontaneous radiation in random directions from the active layer, i.e., in the example, the quantum well. The energy is coupled into the PIN structure 35 where it is absorbed in the intrinsic layer 32. Electron- hole pairs are created and provide for current feedback into the laser. A fraction of this current is again emitted, absorbed in the photodiode, send back to the laser, and so on. The result is that, with the constant DC voltage $V_S$ applied across the whole structure, the laser can be turned ON by applying a small control current $I_{IN}$ to contact 34. The current $I_{IN}$ that is required to cause a current $I_L$ = $I_{th}$ to flow through the laser is, compared with the full current $I_{th}$ that is to be applied to switch a conventional laser 10, reduced by a factor $\beta$ = $I_{th}/I_{IN}$.

This becomes apparent from a numeric example. The threshold current of the GRINSCH laser 10 is approximately $I_{th}$ = 10 mA. About 5 % (or 0.5 mA) of this current is non-radiatively converted into heat, leaving 95 % (or 9.5 mA) that cause random radiative emission. With an effective coupling between the laser and the diode junction, an optical coupling factor of 95 % can be reached. This means that only about 10 % are lost due to non-radiative recombination and to optical losses, i.e., the overall efficiency of the light to current recuperation is in the order of 90 %.

With this, the ratio of the required input signal currents is is

$$\frac{I_{IN}}{I_{th}} = \frac{1}{1 - 0.90} = 10 = \beta$$

In other words, the reduction factor $\beta$ is about 10, i.e., the current required for switching the device from OFF to ON is reduced from 10 mA to 1 mA. The design of the driver providing the switching current can thus be much simpler.

The result is also illustrated in Fig.5, showing the optical output power $P_{out}$ of the laser beam as a function of the applied drive current $I_D$. Curves 51 and 52 characterize the behavior of the conventional laser and that of the inventive device, respectively.

Another important advantage achieved is a substantial improvement in device stability in that temperature and burn-in or extended use effects are substantially reduced. Normally, these have a severe impact on the required threshold current $I_{th}$ whereas their influence on the light emission due to stimulated emission caused by current $I_B$ (see Fig.2) is minimal. For a desired laser beam power, current $I_L$ = $I_{th}$ + $I_B$ required for the laser structure 10. A change in $I_{th}$ of e.g. 5 % has a rather high influence on $I_B$ at constant $I_L$ and thus on the beam power. This effect has to be compensated by using monitor diodes and/or feedback circuitry to maintain the output power at a constant level.

With the device illustrated in Fig.3, the required current $I_{th}$ is reduced by the factor $\beta$, i.e., the required total current $I_L$ = $I_{th}/\beta$ + $I_B$. The same 5 % change in Ith now has an effect on the beam power that is reduced by the factor $\beta$. For many applications, this eliminates the need for monitor diodes or other compensation techniques.

It is noted that the high-speed performance of the laser is not affected since the capacitance per unit area of the PIN diode with a thick absorption layer 32 is much lower than that of the forward biased active laser layer.

Now follows the description of the device operated in the solar cell mode. As previously explained, current $I_L$, flowing through the laser results in the emission of spontaneous radiation from the quantum well. The energy is coupled into PIN structure 35 where it is absorbed in the intrinsic layer 32. Due to the applied voltages $V_L$ = -1.5 V and $V_S$ = - 0.2 V, the pn-junction is forward biased ($V_{LS}$ = + 1.3 V) and, therefore, operates as a solar cell rather than as a photodiode. As apparent from the I/V diagram of Fig.4A, the solar cell, with its operating point determined by $V_{LS}$ = + 1.3 V, absorbs the incident optical energy, converts it into electric energy which is fed back to the laser. This results in lowering the required electric input power. The device is a true low threshold laser with low power dissipation and reduced self-heating.

This becomes apparent from a numeric example. With a threshold current $I_{th}$ of the GRINSCH laser 10 of 10 mA and an applied voltage of $V_L$ = -1.5 V, the power absorbed and dissipated by the conventional laser is P = 15 mW. However, in the structure of Fig.3, most of this energy is coupled into the solar cell 35. Assuming that, as with the previously discussed photodiode version, 10 % of the energy is lost, half by non-radiative recombination and half by optical losses in the coupling between the laser and the solar cell, an input current of only $I_{IN}$ = 1.0 mA is needed to turn the laser ON.

The total power P* required for the laser/solar cell device to reach threshold is then

$$P^* = (I_{IN} \times V_L) + (I_{th} \times V_s)$$
$$= (1 \text{ mA} \times 1.5 \text{ V}) + (10 \text{ mA} \times 0.2 \text{ V}) = 3.5 \text{ mW}$$

Compared with the required power of P = 15 mW for the conventional laser, a reduction of about 75 % in power dissipation is achieved. Device optimization is expected to result in even better performance.

In the embodiment shown in Fig.3, applicable for both modes of operation, i.e., the PIN diode being operated as either a photodiode or as a solar cell, the particular laser (10) and pn-junction (35) structures can be replaced by other elements of similar characteristics. For instance, the ridge GRINSCH laser can be replaced by a so-called channeled substrate laser as described, e.g, in the article "Patterned Quantum Well Semiconductor Injection Laser grown by Molecular Beam Epitaxy" by E.Kapon et al (Appl. Phys. Lett. 52-(8), 22 February 1988, pp 607-609). Similarly, pn-junction diode structures other than the PIN diode herein described can be used.

In a further embodiment of the invention, the laser 10 of the device is replaced by a light emitting diode (LED) structure, i.e., a forward biased pn-junction wherein energy is set free by recombination of electrons and holes and emitted as random radiation.

Whereas lasers are very efficient light sources and have bandwidth well exceeding 5 GHz, they tend to be single mode and have a long coherence length. LED outputs, on the other hand, have several modes and a short coherence length but, generally, have a very low efficiency of about 5 % and cannot be modulated at high frequencies because of the limited number of carriers available. These latter drawbacks of conventional LED structures are substantially overcome by the devive shown in Fig.6.

Fig.6 schematically illustrates a side view of the device 60. As in the previously described embodiments, the light-emitting element 10 is grown on top of a pn-junction diode structure 35. The element 10 again consists of a GRINSCH structure but this is kept from lasing by making the cavity length L short, e.g., 20 to 50 $\mu$m. This in contrast to the lasing structure having a length of between 500 and 1000 um. Also, an antireflection coating 61 (0.14 $\mu$m SiO$_2$) is added on one facet whereas, for maximum efficiency, the reflectivity of the opposite facet is increased by a stack of dielectric layers 62 with alternating refractory indices (0.14 $\mu$m SiO$_2$/0.12 $\mu$m Si$_3$N$_4$). A plasma enhanced chemical vapor deposition (PECVD) process can be used to form these layers.

For the pn-junction 35, the same PIN diode structure as that used in the device of Fig.3 is employed and operated as a solar cell.

In the device of Fig .6, energy is, as in the previous embodiment, recuperated at the pn-junction of the PIN diode 35 and fed back to the LED. This results in a large carrier density within the quantum well, achieved with a low control current $I_{IN}$ applied.

The increased efficiency of the LED structure of Fig .6. becomes apparent from the following numeric example :

For the LED structure without the PIN diode, the efficiency $\eta$ i.e., the ratio between the resulting optical power output and the electric power input, is about 5 %. With the diode 35 in place, this output radiation is not absorbed at the pn-junction of the PIN diode since it leaves the LED as output beam 63 which is not coupled to the diode. Of the remaining 95 % of the applied electric energy, almost entirely converted into radiant energy, about 90 % are absorbed and fed back to the LED. With this, the resulting efficiency of the device is

$$\eta^* = \frac{\eta}{1-(0.90-\eta)} = \frac{0.5}{1-(0.90-0.05)} = \text{about } 30\%$$

In other words, due to the energy recuperation, the efficiency is increased by a factor of about 6.

The energy recuperation results, similar to the improvements achieved in the earlier decribed embodiments, in reduced heat dissipation which, in turn, allows a higher carrier density and thus high speed operation. The LED device of Fig.6 is particularly useful in multi-mode fiber link communication systems where a multi-mode light source with low coherence length is required to avoid modal noise and reflection induced noise.

## Claims

1. Opto-electronic light emitting semiconductor device (30, 60) formed in a structure of III-V compound layers grown on a substrate, with ohmic top (36) and bottom (37) contacts and not requiring an external light-source for its operation,
comprising
- a light emitting element (10) and a pn-junction diode (35), both grown back-to-back in an epitaxial growth process, and
- a middle layer (33), common to both, said light-emitting element (10) and said pn-junction diode (35), that is transparent for the emitted wavelength and provided with an ohmic contact (34) for applying control signals to the device,
the light emitting element and the pn-junction diode being optically coupled so that at least 50 % of the electric energy fed into the light emitting element and emitted as spontaneous radiation, can be recuperated at the pn- junction.

2. A light emitting device as in claim 1, wherein said light emitting element (10) is a diode laser.

3. A light emitting device as in claim 2, wherein said diode laser is a ridge waveguide graded-index separate confinement heterostructure device.

4. A light emitting device as in claim 2, wherein said laser diode is a channeled substrate graded-index separate confinement heterostructure device.

5. A light emitting device as in claim 1, wherein said light emitting element (10) is a light emitting diode.

6. A light emitting device as in claim 5, wherein said light emitting diode is a graded-index separate confinement heterostructure (60) device with a cavity length below that required for laser action.

7. A light emitting device as in claim 6, wherein a first facet of the cavity is covered with an antireflection coating (61) and the second facet with a stack of dielectric layers of alternating refractive indices (62).

8. A method of operating a light emitting device as claimed in claim 1, wherein the ohmic contacts (34, 37) of said pn-junction diode are connected to a voltage source of such polarity that the pn-junction is reverse-biased thus operating as a photodiode.

9. A method of operating a light emitting device as claimed in claim 1, wherein the ohmic contacts (34, 37) of said pn-junction diode are connected to a voltage source of such polarity that the pn-junction is forward-biased thus operating as a solar cell.

## FIG.1 PRIOR ART

FRONT VIEW

## FIG. 2

NON-RADIATIVE    SPONTANEOUS RADIATION    STIMULATED RADIATION

## FIG.3

FRONT VIEW

FIG. 4A

FIG. 4B

PD

SC

FIG. 5

FIG. 6

SIDE VIEW

# DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| X | GB-A-2 135 116  (ITT INDUSTRIES INCORPORATED) <br> * Page 3, lines 21-65; figure 5 * | 1,2,5,9 | H 01 L  33/00 <br> H 01 S   3/025 |
| A | US-A-3 881 113  (V.L. RIDEOUT et al.) <br> * Figure 2; column 4, line 67 - column 5, line 65 * | 1,5,8 | |
| A,D | EP-A-0 260 439  (MITSUBISHI DENKI K.K.) <br> * Figure 1; column 3, lines 38-58 * | 1,2 | |
| A,D | IBM TECHNICAL DISCLOSURE BULLETIN, vol. 31, no. 12, May 1989, page 180, New York, US: "Opto-electronic amplifier and logic element" | 1,2 | |
| A | PATENT ABSTRACTS OF JAPAN, vol. 6, nr. 32 (E-96)[910], 26th February 1982; & JP-A-56 150 888 (MATSUSHITA DENKI SANGYO K.K.) 21-11-1981 <br> * Whole document * | 1 | |
| A,D | ELECTRONICS LETTERS, vol. 22, no. 20, 25th September 1986, pages 1081-1082, New York, US; C. HARDER et al.: "High-power ridge-waveguide AlGaAs GRIN-SCH laser diode" <br> * Whole document * | 1,2,3 | TECHNICAL FIELDS SEARCHED (Int. Cl.5) <br><br> H 01 L <br> H 01 S |

The present search report has been drawn up for all claims

| Place of search | Date of completion of the search | Examiner |
|---|---|---|
| THE HAGUE | 01-03-1990 | LINA F. |